# EUROPÄISCHE PATENTANMELDUNG

(11) **EP 0 792 014 A2**
(43) Veröffentlichungstag der Anmeldung: **27.08.1997**
(21) Anmeldenummer: 97101775.1
(22) Anmeldetag: 05.02.1997
(51) Int. Cl.: H03G 3/00

(54) **Anordnung zur Regelung der Ausgangsamplitude eines Hochfrequenz-Leistungsverstärkers**

(30) Priorität: 23.02.1996 DE 19606799
(71) Anmelder: Daimler-Benz Aerospace Aktiengesellschaft, 81663 München (DE)
(72) Erfinder: Ludwig, Michael, 89155 Erbach (DE); Wahl, Marcus, 89134 Blaustein (DE)
(74) Vertreter: Fröhling, Werner, Dr.

(57) **Zusammenfassung**

Die Erfindung betrifft einen geregelten gesättigten Hochfrequenz-Leistungsverstärker, der insbesondere als Sendeverstärker in einem T/R-Modul für eine phasengesteuerte (Radar-)Antenne für das X-Band (8 GHz bis 12 GHz) einsetzbar ist. Dabei wird aus einem Teil des HF-Ausgangssignals ein Regelsignal erzeugt, mit welchem über mindestens einen Gate-Anschluß der in dem Leistungsverstärker vorhandenen HF-Leistungsfeldeffekttransistoren eine nahezu verlustlose Regelung der Ausgangsleistung erfolgt. Der Leistungsverstärker hat daher einen hohen Sendewirkungsgrad, auch bei einem gepulsten Sendebetrieb.

## Beschreibung

Die Erfindung geht aus von einer Anordnung zur Regelung der Ausgangsamplitude eines Hochfrequenz-Leistungsverstärkers nach dem Oberbegriff des Patentanspruchs 1.

Die Erfindung findet beispielsweise Anwendung in einer Temperaturkompensation für Leistungsverstärker mit einer Pulsleistung von ungefähr 10 Watt für den GHz-Bereich (X-Band; 8 GHz bis 12 GHz). Die Erfindung ist aber nicht auf dieses Frequenzband sowie diese Leistungsklasse beschränkt.

Solche Leistungsverstärker werden beispielsweise in der Radartechnologie benötigt als Sendeverstärker in Sende/Empfangsmodulen (T/R-Module) für phasengesteuerte Antennen. Bei solchen T/R-Modulen wird das Ausgangssignal der Leistungsverstärker im allgemeinen unmittelbar, insbesondere ohne Phasen- und/oder Amplitudenstellglied, einem (Sende-)Strahlerelement zugeleitet. Für eine Schwenkung und/oder Formung des Sende-Richtdiagrammes einer solchen Antenne ist es erforderlich, daß zwischen den von benachbarten Strahlerelementen ausgesandten Wellen möglichst genau vorgebbare Phasen- und Amplitudenbedingungen eingehalten werden. Werden nun bei einer solchen Antenne eine Vielzahl, beispielsweise einige Tausend, solcher T/R-Module verwendet, so ist in ersichtlicher Weise ein hoher Meß-, Kalibrier- sowie Abgleichaufwand erforderlich, um die geforderten Phasen- und/oder Amplitudenbedingungen einzustellen und/oder zu überprüfen. Außderdem müssen bei jedem T/R-Modul in nachteiliger Weise die erforderlichen Meß- sowie Einstellmöglichkeiten (Bauelemente) vorhanden sein. Diese sind in nachteiliger Weise unter anderem selbst störanfällig und kostenungünstig.

Der Erfindung liegt daher die Aufgabe zugrunde, eine gattungsgemäße Anordnung anzugeben, mit der eine genaue Regelung der Ausgangsamplitude eines Leistungsverstärkers möglich ist und die räumlich klein, mechanisch robust, zuverlässig sowie kostengünstig herstellbar ist, insbesondere bei einer industriellen Serienfertigung.

Diese Aufgabe wird gelöst durch die im kennzeichnenden Teil des Patentanspruchs 1 angegebenen Merkmale. Vorteilhafte Ausgestaltungen und/oder Weiterbildungen sind den weiteren Ansprüchen entnehmbar.

Ein erster Vorteil der Erfindung besteht darin, daß die Anordnung vollständig in Halbleitertechnologie, insbesondere in GaAs-Technologie für Höchstfrequenzanwendungen, ausführbar ist.

Ein zweiter Vorteil besteht darin, daß selbst Amplitudenänderungen, die aufgrund von Temperaturänderungen (Temperaturdrift) im Leistungsverstärker entstehen, erfaßt und ausgeregelt (kompensiert) werden.

Ein dritter Vorteil besteht darin, daß die Anordnung einen hohen Wirkungsgrad besitzt. Das heißt, es entsteht zusätzlich durch die Regelung allenfalls ein vernachlässigbarer Anteil von Verlustwärme. Ein hoher Wirkungsgrad ist insbesondere dann vorteilhaft, wenn eine Vielzahl von Leistungsverstärkern im wesentlichen gleichzeitig betrieben werden, beispielsweise in den T/R-Modulen einer eingangs erwähnten phasengesteuerten Antenne.

Weitere Vorteile ergeben sich aus der nachfolgenden Beschreibung.

Die Erfindung wird im folgenden anhand von Ausführungsbeispielen unter Bezugnahme auf schematisch dargestellten Figuren näher erläutert. Es zeigen
- FIG. 1: ein schematisch dargestellten Beispiel
- FIG. 2: eine bisher verwendete Anordnung
- FIG. 3, FIG. 4: weitere schematisch dargestelle Beispiele zur Erläuterung der Erfindung.

Die Erfindung basiert auf einer Verstärkeranordnung, die insbesondere als Leistungsverstärker (Sendeverstärker) für den Mikrowellenlängenbereich, beispielsweise den Bereich von 8 GHz bis 12 GHz (X-Band), geeignet ist. Werden solche Verstärker in T/R-Modulen einer phasengesteuerten Antenne verwendet, so sollten die Verstärker über in einem möglichst großen Temperaturbereich (Arbeitsbereich) eine möglichst hohe Amplitudengenauigkeit besitzen, das heißt, eine vorgebbare Leistungsverstärkung sollte in dem Arbeitsbereich immer einen möglichst kleinen (engen) Toleranzbereich aufweisen. Eine vorgebbare Amplitudengenauigkeit ist erreichbar mittels einer davon abhängigen Regelschaltung zur Regelung der Ausgangsleistung des Verstärkers. Ist dieser als sogenannter linearer Leistungsverstärker ausgebildet, so kann diese Regelung beispielsweise mittels eines Amplitudenstellgliedes am HF-Eingang des Verstärkers erfolgen.

Insbesondere bei einer Anwendung in T/R-Modulen hat es sich als zweckmäßig erwiesen, sogenannte gesättigte Leistungsverstärker zu verwenden. Diese arbeiten vorzugsweise mit der maximal möglichen (HF-)Leistung. Diese ist dann lediglich von der gewählten Betriebsspannung und/oder dem gewählten Betriebsstrom abhängig. Für eine Regelung der Ausgangsleistung (Ausgangsamplitude) solcher gesättigter Leistungsverstärker ist daher eine Regelung der Betriebsspannung und/oder des Betriebsstroms in Abhängigkeit von der Ausgangsamplitude erforderlich.

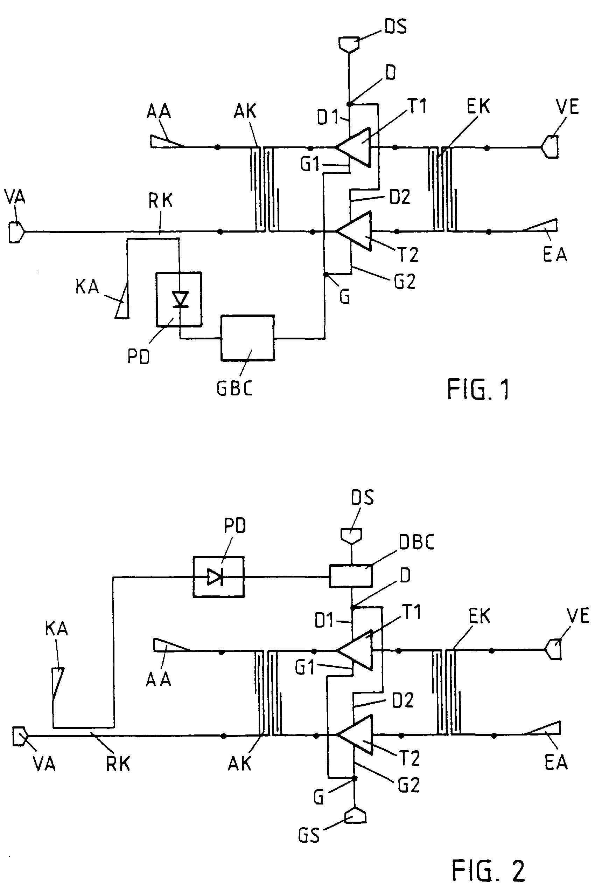

FIG. 2 zeigt einen solchen gesättigten Leistungsverstärker mit einer Regelung der Betriebsspannung in Abhängigkeit von der Ausgangsamplitude. Der Leistungsverstärker besteht beispielsweise aus zwei Feldeffekttransistoren T1, T2, bei denen sowohl jeweils die Gate-Anschlüsse G1, G2 als auch jeweils die Drain-Anschlüsse D1, D2 parallel geschaltet sind zu einem gemeinsamen Gate-Anschluß G sowie einem gemeinsamen Drain-Anschluß D. Ein zu verstärkendes Eingangssignal, z.B. ein Radar-Sendesignal, gelangt über den Verstärker-Eingang VE, eine Eingangs-Koppelanordnung EK, mit Eingangs-Abschluß EA (HF-Sumpf), auf die Feldeffekttransistoren T1, T2, wird dort verstärkt und gelangt über eine Ausgangs-Koppelanordnung AK, mit Ausgangs-Abschluß AA (HF-Sumpf) auf den Verstärker-Ausgang VA. Dieser ist bei einem T/R-Modul im wesentlichen über einen Sende/Empfangs-Umschalter an ein Sende/Empfangs-Strahlerelement anschließbar.

Zur Regelung der Ausgangsleistung (Ausgangsamplitude) wird nun am Verstärker-Ausgang VA über einen Koppler RK, mit Abschluß KA (HF-Sumpf) ein vorgebbare Anteil, beispielsweise ungefähr -20dB, des Ausgangssignales ausgekoppelt und in einem Spitzenwert-Detektor PD gleichgerichtet. An dessen Ausgang entsteht im wesentlichen ein niederfrequentes Meßsignal (Regelgröße) mit einem Gleichspannungsanteil. Das Meßsignal entspricht der Amplitude des Ausgangssignales am Verstärker-Ausgang VA. Dieses Meßsignal wird einer Drain-Regelschaltung DBC zugeführt, die zwischen dem gemeinsamen Drain-Anschluß D und einer (ungeregelten) Drain-Spannungs/Stromversorung DS angeordnet ist. An den mit GS bezeichneten Anschluß ist eine Gate-Spannung anlegbar zur Einstellung des Arbeitspunktes der Transistoren T1, T2.

Es ist ersichtlich, daß bei einer solchen Anordnung in nachteiliger Weise in der Drain-Regelschaltung DBC eine nicht vernachlässigbare Verlustleistung auftritt, da ansonsten keine Regelung möglich ist. Diese Verlustleistung (Wärme) erfordert nachteiligerweise eine technisch aufwendige Kühlanordnung und bewirkt außerdem einen geringen Senderwirkungsgrad.

FIG. 1 zeigt ein erfindungsgemäßes Ausführungsbeispiel, bei welchem neben einer hohen Amplitudengenauigkeit ein hoher Senderwirkungsgrad (vernachlässigbare (Wärme-)Verlustleistung) erreicht wird. Die dargestellte Anordnung ist weiterhin vorteilhafterweise für gepulste Sender verwendbar, welche in der Radartechnologie derzeit üblich sind, insbesondere in T/R-Modulen. Die Anordnung unterscheidet sich von derjenigen entsprechend FIG. 2 im wesentlichen dadurch, daß die im wesentlichen ungeregelte (oder allenfalls gering geregelte) Versorgungsspannung DS unmittelbar an dem gemeinsamen Drain-Anschluß D anliegt. Die erforderliche Regelung der Ausgangsleistung (Ausgangsamplitude) erfolgt ensprechend FIG. 1 im wesentlichen (verlust-)leistungslos über eine Gate-Regelspannung, welche dem gemeinsamen Gate-Anschluß G der Transistoren T1, T2 zugeführt wird und dadurch den Drainstrom der Transistoren T1, T2 beeinflußt.

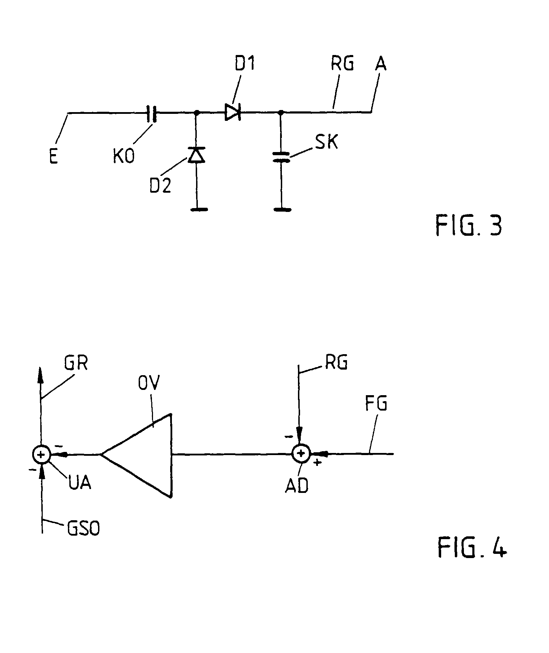

Zur Erzeugung der Gate-Regelspannung wird am Verstärkerausgang VA ein vorgebbarer Teil der Ausgangsleistung über einen Koppler RK, beispielsweise eine 20dB-Koppler, ausgekoppelt und über eine Spannungsverdopplerschaltung PD ("Peak Detector") gleichgerichtet. Dabei entsteht eine Gleichspannung, die im hier dargestellten Beispiel ungefähr zweimal der Spitzenspannung entspricht, welche am Verstärker-Ausgang VA anliegt. Diese Gleichspannung wird als Regelgröße verwendet und einer (Gate-)Regelschaltung GBC zugeführt. Dort erfolgt ein Soll-Istwert-Vergleich der Regelgröße mit einer vorgebbaren Führungsgröße (Soll-Spannung). Die bei dem Vergleich sich ergebende Regelabweichung wird bedarfsweise verstärkt, damit den Betriebsparametern der verwendeten Transistoren T1, T2 angepaßt und dem gemeinsamen Gate-Anschluß G zugeleitet. Dieser Regelkreis wird anhand der FIG. 3, FIG. 4 noch näher erläutert.

FIG. 3 zeigt das Schaltbild einer Spannungsverdopplerschaltung PD. Dabei wird das am Eingang E anliegende HF-Signal über einen Koppelkondensator KO einem Gleichrichter, der aus den Dioden D1, D2 besteht, zugeführt. Die entstandene Gleichspannung (Regelgröße) wird mittels eines Speicherkondensators SK geglättet (Tiefpaßwirkung). Dessen Größe (Kapazität) ist abhängig von der geforderten Zeitkonstanten des Regelkreises, was einem Fachmann geläufig ist. Außerdem ist die Kapazität so wählbar, daß auch bei gepulstem Sendebetrieb (gepulste Sender) nahezu unabhängig von der Pulsdauer eine im wesentlichen konstante Regelgröße ensteht am Ausgang A der Spannungsverdopplerschaltung.

Diese Regelgröße wird nun der (Gate-)Regelschaltung GBC (FIG. 1) zugeführt. Diese ist entsprechend der geforderten Regel-Charakteristik sehr unterschiedlich ausführbar, beispielsweise als P-Regler (Proportional-Regler) entsprechend FIG. 4 unter Verwendung eines Operationsverstärkers.

Entsprechend FIG. 4 wird die Regelgröße RG am Eingang des Operationsverstärkers OV verglichen mit einer Führungsgröße FG, beispielsweise einer einstellbaren, gut stabilisierten (Referenz-)Gleichspannung. Dieser Vergleich erfolgt in der dargestellten Weise mittels einer Addierstufe AD oder alternativ mittels der Differenzeingänge des Operationsverstärkers. Am Ausgang der Addierstufe AD ensteht eine der Regelabweichung entsprechende Spannung, die im Operationsverstärker OV verstärkt und dann einem Eingang eines Umkehraddierers UA zugeführt wird. Dem anderen Eingang wird eine Gate-Sollspannung GSO zur Arbeitspunkteinstellung der Transistoren T1, T2 (FIG. 1) zugeführt. Die am Ausgang des Umkehraddierers UA erzeugte Spannung GR wird dem gemeinsamen Gate-Anschluß G (FIG. 1) zugeführt.

Mit einer derartigen Anordnung, wobei auch die Addierstufen AD, UA als Operationsverstärker ausgebildet sind, ist beispielsweise in einem Temperaturbereich von ungefähr - 40°C bis + 60°C (233 K bis 333 K) bei der Ausgangsleistung eine Amplitudengenauigkeit von ± 0,15dB erreichbar. Ohne Regelung ist in diesem Temperaturbereich dagegen lediglich eine Amplitudengenauigkeit von ± 0,6dB vorhanden.

Die Erfindung ist nicht auf die beschriebenen Ausführungsbeispiele beschränkt, sondern sinngemäß auf weitere anwendbar, beispielsweise bei T/R-Modulen in Satelliten, bei denen ebenfalls ein hoher Wirkungsgrad bei hoher Amplitudengenauigkeit in einem großen Temperaturbereich gefordert ist.

Außerdem ist die Erfindung nicht auf die Verwendung von Feldeffekttransistoren (FETs) als Hochfrequenz (HF) - Leistungsverstärker beschränkt, sondern dafür sind prinzipiell alle HF-Verstärkerelemente geeignet, welche mindestens einen HF-Eingang, einen HF-Ausgang, einen Gleichspannungsversogungs-Anschluß sowie einen Steuerspannungs-Anschluß besitzen. Solche HF-Verstärkerelemente sind beispielsweise Elektronenstrahlröhren, sogenannte HBTs sowie Dualgate-FETs. Hierbei ist es nicht notwendig, daß die Gleich- und/oder Steuerspannungsanschlüsse sowie die HF-Eingangs- sowie HF-Ausgangsanschlüsse geometrisch getrennt sind.

Weitere Anwendungen derart geregelter HF-Verstärker liegen beispielsweise auf dem Gebiet der Meßtechnik, auf welchem ebenfalls hochgenaue HF-Verstärker benötigt werden, sowie bei allen Anwendungen, bei denen eine Kompensation von (Transistor-)Herstellungstoleranzen erforderlich ist.

## Patentansprüche

1. Anordnung zur Regelung der Ausgangsamplitude eines Hochfrequenz-Leistungsverstärkers mit maximal möglicher HF-Leistung, wobei eine Regelschaltung vorhanden ist, mit welcher
- mittels eines Spitzenwertgleichrichters aus der Ausgangsamplitude ein Ist-Signal gebildet wird,
- das Ist-Signal mit einem entsprechenden Soll-Signal verglichen wird,
- aus dem Ist-/Soll-Signal Vergleich ein Regelsignal gebildet wird und
- mit dem Regelsignal eine Versorgungsspannung und/oder ein Versorgungsstrom des Leistungsverstärkers derart geregelt wird, daß die Augangsamplitude entsprechend eines vorgebbaren Wertes geregelt wird, dadurch gekennzeichnet,
- daß als HF-Leistungsverstärker mindestens ein HF-Verstärkerelement (T1, T2) mit mindestens einem HF-Eingang, einem HF-Ausgang, einem Gleichspannungsanschluß sowie einem Steuerspannungsanschluß vorhanden ist, wobei der Gleichspannungsanschluß (D1, D2) an eine Spannungs- und/oder Stromversorgungseinheit anschließbar ist,
- daß in einer Gate-Regelschaltung (GBC) aus dem Ist-Signal sowie einem vorgebbaren Soll-Signal, das entsprechend den elektrischen Parametern des mindestens einen Verstärkerelementes (T1, T2) gewählt ist, ein Regelsignal gebildet wird zur Ansteuerung des Steuerspannungsanschlusses (G1, G2) des mindestens einen HF-Verstärkerelementes (T1, T2).

2. Anordnung nach Anspruch 1, dadurch gekennzeichnet, daß das Regelsignal mittels eines Operationsverstärkers (OV), der als Proportionalregler geschaltet ist, gebildet wird.

3. Anordnung nach Anspruch 1 oder Anspruch 2, dadurch gekennzeichnet, daß in dem Spitzenwertgleichrichter (PD) eine Spitzenwertgleichrichtung mittels einer Einweggleichrichtung erfolgt unter Verwendung von zwei Dioden (D1, D2).

4. Anordnung nach einem der vorhergehenden Ansprüche zur Verwendung als geregelter Leistungsverstärker für den Radar-Frequenzbereich.

5. Anordnung nach einem der vorhergehenden Ansprüche zur Verwendung als geregelter Sendeverstärker für das X-Band.

6. Anordnung nach einem der vorhergehenden Ansprüche zur Verwendung in einem Sende-/Empfangsmodul (T/R-Modul) für eine phasengesteuerte Antenne.

7. Anordnung nach einem der vorhergehenden Anspüche dadurch gekennzeichnet, daß mindestens ein HF-Verstärkerelement (T1, T2) als Feldeffekttransistor ausgebildet ist.

8. Anordnung nach einem der vorhergehenden Anspüche dadurch gekennzeichnet, daß zumindest ein Feldeffekttransistor (T1, T2), der Spitzenwertdetektor (PD) sowie die Gate-Regelschaltung (GBC) in einer für das X-Band geeigneten integrierten Halbleitertechnologie ausgebildet sind.
